# EUROPEAN PATENT APPLICATION

(11) **EP 4 530 653 A1**
(43) Date of publication of application: **02.04.2025**
(21) Application number: 23200746.8
(22) Date of filing: 29.09.2023
(51) Int. Cl.: G01R 33/36

(54) **SIGNAL TRANSMISSION LINE ARRANGEMENT**

(71) Applicant: Koninklijke Philips N.V., 5656 AG Eindhoven (NL)
(72) Inventor: LEUSSLER, Christoph Günther, Eindhoven (NL); FINDEKLEE, Christian, Eindhoven (NL); VERNICKEL, Peter, 5656AG Eindhoven (NL)
(74) Representative: Philips Intellectual Property & Standards

(57) **Abstract**

According to the invention, a signal transmission line arrangement (1) for a radio frequency antenna system (2) of a magnetic resonance examination (18) apparatus comprising at least two leads (3) arranged within a conductive shielding (16), the leads (3) being galvanically conductive and extending from a first end (8) to a second end (10), wherein the leads (3) are reactively coupled by at least one reactive element (5) galvanically interconnected between the first ends (8) and the second ends (10), such that the leads (3) are connected in parallel with the respective reactive element (5) and the reactive coupling gives rise to respective different transmission modes of signal propagation of signals in respective frequency bands. In this way, a signal transmission line arrangement (1) with more flexible cabling is provided.

## Description

### FIELD OF THE INVENTION

The invention relates to the field of magnetic resonance examination. In particular, the present invention relates to the field of signal transmission in a magnetic resonance examination apparatus.

### BACKGROUND OF THE INVENTION

A part of every magnetic resonance examination apparatus is the radio frequency antenna system for receiving and converting the magnetic resonance signal. Herein, magnetic resonance examination apparatuses include magnetic resonance imaging apparatuses primarily intended for diagnostic imaging on a patient and nuclear magnetic resonance apparatuses. The radio frequency antenna system comprises among other features at least a radio frequency coil, a preamplifier and an analog-to-digital converter. In magnetic resonance examination a system integrated body coil generates the excitation magnetic field via transmit radio frequency signals for the spin system causing a preceding relaxation. The precession of the net magnetization induces a current in the radio frequency coil via electromagnetic induction. Typically, the transmit radio frequency signals are orders of magnitude greater than the currents induced in the radio frequency coil by the precession of the net magnetization. To protect a patient and the radio frequency antenna system, the radio frequency coils can be decoupled or detuned during a transmit phase of the magnetic resonance examination apparatus in which the transmit radio frequency signal is emitted. Radio frequency coil detuning is the shifting of the resonant frequency of a primary resonant circuit of the radio frequency coil to one or more other frequencies different from the original frequency so that the transmit radio frequency cannot cause damage to the radio frequency coil.

For this purpose, a detuning circuit is usually connected in parallel to the radio frequency coil, for detuning the resonance frequency of the radio frequency coil. Usually, PIN diodes are used for this purpose, but they require a bias current of typically 80 mA direct current. This means that not only must a radio frequency signal received by the radio frequency coil be transmitted with a cable of a large cross section, but another cable, which can be loaded with 80 mA direct current, must also supply the PIN diode at the same time.

In contrast, a magnetic resonance coil array with a single coaxial transmission line is known from US 10 215 818 B2. Here the single coaxial transmission line is provided between the radio frequency receiver coil and a receiver and between a driver circuit and the detuning circuit. The single coaxial transmission line conveys the radio frequency signals from the radio frequency receiver coil to the receiver. Voltage is supplied from the driver circuit as a power signal to a preamplifier of the radio frequency receiver coil. The driver circuit is configured to switch the signal voltage level and control the detuning circuit based on the voltage level of the power.

### SUMMARY OF THE INVENTION

It is an object of the invention to provide a signal transmission line with more flexible cabling.

According to the invention, this object is addressed by the subject matter of the independent claims. Preferred embodiments of the invention are described in the dependent claims. Therefore, according to the invention, a signal transmission line arrangement for a radio frequency antenna system of a magnetic resonance examination apparatus comprising at least two leads arranged within a conductive shielding, the leads being galvanically conductive and extending from a first end to a second end, wherein the leads are reactively coupled by at least one reactive element galvanically interconnected between the first ends and the second ends, such that the leads are connected in parallel with the respective reactive element and the reactive coupling gives rise to respective different transmission modes of signal propagation of signals in respective frequency bands.

An insight of the present invention is that by reactive, i.e., capacitive or inductive coupling of the leads in the galvanically conductive shielding results in different transmission modes which have different resistances for respective frequency bands. Here, the term frequency bands refers to the different frequency ranges of the signals to be transmitted. In magnetic resonance imaging, the magnetic resonance image signals received with radio frequency coils are received in and transmitted in the radio frequency band. These signals are therefore radio frequency signals. Accordingly, control signals can be transmitted in lower frequency bands, for example. The signal transmission line is now designed in such a way that it can provide different transmission modes for these different frequency bands, depending on the configuration or design of the reactive element.

The signal transmission line comprises at least two leads that are connected to a reactive element at their respective ends in such a way that the leads are connected in parallel with one another via the reactive element. In addition, further leads can be provided, whereby these are also connected in parallel to each other with reactive elements, so that with a number of N leads, a number of N-1 reactive elements are required in order to connect these to each other in the intended manner. These further leads could then be used, for example, to control sensors and/or supply the sensors with power.

In practice the leads of the signal transmission line arrangement may be implemented as galvanically conductive wires.

Here it is preferable that the leads each extend from first ends to second ends, the first ends and the second ends being the locations wherein the reactive elements are interconnected.

In general, different reactive elements can be provided. According to a preferred embodiment of the invention, however, the at least one reactive element is at least one capacitive unit, such that the capacitive coupling of the leads gives rise to a coaxial mode supported by both leads for radio frequency signal transmission, wherein the capacitive unit is configured for having a lower capacitive resistance in a radio frequency band, and a differential mode supported by the conductive shielding and one of the leads for transmission of a low-frequency band control signal, wherein the capacitive unit is configured for having a higher capacitive resistance in the low-frequency band.

The capacitive unit is thus designed in such a way that the radio frequency signal is transmitted with the first lead together with the second lead against the shared ground, and that furthermore the control signal is transmitted with the lead to which it is applied and the conductive shielding. The conductive shielding carries the ground potential. This means that the capacitive unit contacts the first lead and the second lead at least two locations respectively, the first ends and the second ends. The control signal is a signal that can be used to control and supply power to various circuits and/or sensors. Because the signal transmission line arrangement can be used for different transmissions, the lead cross-section required for the transmission itself is reduced. In contrast, if the radio frequency signal were transmitted with a single cable, an additional cable would be needed for the transmission of the control signal, such that the total cable cross-section would be increased by a multiple.

Here the capacitive resistance must be separated from the characteristic impedance. The capacitive resistance is the resistance of the capacitive unit, which becomes small, i.e., passable for the radio frequency signal and high, i.e. not passable for the control signal, which has a low frequency. The characteristic impedance is now the ratio of the voltage of the leads to ground/conductive shielding for the coaxial mode or the voltage between the leads in the differential mode and the current with the same amplitude but opposite directions in lead/shielding for the coax mode or in the two leads in the differential mode. The characteristic impedance is therefore not changed by the capacitors.

The lead to which the control signal is not applied can then be employed to supply power to an active component. In particular, it is advantageous here that two separate modes, the control signal and the power supply, can be transmitted with a first lead and a second lead, and the interference of these two modes with each other is minimized by the separate transmission paths in the respective leads.

According to a preferred embodiment of the invention, the at least one reactive element is at least one inductive unit, such that the inductive coupling of the leads gives rise to a coaxial mode supported by both leads for transmission of a low-frequency band control signal, wherein the inductive unit is configured for having a lower inductive resistance in the low-frequency band, and a differential mode supported by the two leads for radio frequency signal transmission, wherein the inductive unit is configured for having a higher inductive resistance in a radio frequency band.

The inductive unit is thus designed in such a way that the control signal is transmitted with the first lead and the second lead, and that furthermore the control signal is transmitted with a coax mode using both lead in parallel and the conductive shielding. This means that the inductive unit contacts the first lead and the second lead at least two locations respectively, the first ends and the second ends.

In another embodiment, an inductive coupling of the control signal may just be used to feed that control signal into one of the leads and omit any reactive coupling of the two leads. In that way, the differential mode may be used to transmit the radio frequency signal while just one of the leads contains the control signal.

In principle the capacitive unit can be formed in different ways. According to a preferred embodiment of the invention, however, the at least two leads comprise a first lead and a second lead and the capacitive unit comprises a first capacitor and a second capacitor and the first capacitor and the second capacitor are each interconnected between the first ends and the second ends of the first lead and the second lead such that the radio frequency signal is transmittable employing the first lead and the second lead in the coaxial mode against a ground potential in the conductive shielding, and the control signal is transmittable in the differential mode employing the first lead and the conductive shielding or the second lead and the conductive shielding.

Preferably, the first lead and the second lead are twisted with each other. By twisting the leads, interference factors that could affect the signal transmission have an almost identical influence on both the first lead and the second lead as corresponding sections in the first and second leads see the same spatial angle. In addition, any distortions from the signals in the cables on the highly sensitive receive coils are minimized.

Because the conductive shielding provides a ground potential it is also possible to transmit the control signal as an offset voltage. Likewise, the ground potential can be provided for active components and/or further circuits, such as a detuning circuit for detuning the radio frequency coil. By placing the first lead and the second lead in a common conductive shielding, a compact and robust design of the signal transmission line arrangement is possible. The signal transmission line arrangement can be realized in such a way in a single flexible cable.

Furthermore, by transmitting the radio frequency signal in the coaxial mode, the first lead and the second lead only carry the radio frequency signal and no other signals that could interfere with the radio frequency signal being transmitted in the relevant transmission mode with the first lead or the second lead. The coaxial mode and the differential mode are thus operated simultaneously on the signal transmission line arrangement.

The first capacitor and the second capacitor are thus configured for having a lower capacitive resistance in case of radio frequency signal transmission in the coaxial mode, and a higher capacitive resistance in the case of low-frequency control signal transmission in the differential mode.

Similarly, the dissipation of the radio frequency signal is counteracted due to the conductive shielding by providing the ground potential against the radio frequency signal being transmitted with the first lead and the second lead in the coaxial mode.

The control signal therefore has a frequency that is orders of magnitude lower than the radio frequency band. This means that the control signal can be a low-frequency alternating current/voltage signal or a direct current/voltage signal, wherein the frequency of the direct current signal is zero. The first capacitor and the second capacitor have high capacitive resistance when the control signal is transmitted via the signal transmission line arrangement and low capacitive resistance when the radio frequency signal is transmitted via the signal transmission line arrangement. For the radio frequency bands commonly used for magnetic resonance imaging, the capacitors are supposed to have a capacitance in the range between 0.3 and 20 nF.

It is possible to form the inductive unit in different ways. According to a preferred embodiment of the invention, however, the at least two leads comprise a first lead and a second lead and the inductive unit comprises a first inductor and a second inductor and the first inductor and the second inductor are each interconnected between the first ends and the second ends of the first lead and the second lead such that the control signal is transmittable employing the first lead and the second lead in the coaxial mode, and the radio frequency signal is transmittable in the differential mode employing the first lead and the conductive shielding or the second lead and the conductive shielding.

By transmitting the control signal in the coaxial mode, the first lead and the second lead only carry the control signal and no other signals that could interfere with the control signal being transmitted in the relevant transmission mode with the first lead or the second lead.

The first inductor and the second inductor are thus configured for having a higher inductive resistance in case of radio frequency signal transmission in the differential mode, and a lower inductive resistance in the case of low-frequency control signal transmission in the coaxial mode. For radio frequency bands commonly used for magnetic resonance imaging, the inductors have an inductive resistance in the range between 50 and 150 ohms.

According to a preferred embodiment of the invention, the first lead, the second lead and the conductive shielding are formed by a twin axial cable or a shielded twisted pair cable, wherein the first lead and the second lead are formed by the inner conductors of the twin axial cable or the twisted pair cable, and the conductive shielding is formed by the shielding of the twin axial cable or the shielding of the twisted pair cable. The shielded twisted pair cable also provides conductive shielding that can be used to form the conductive shielding of the signal transmission line arrangement. Here, the twin axial cable is preferably a micro twin axial cable.

Twin axial cabling or "Twinax", is a type of cable similar to a coaxial cable, but with two inner conductors instead of one. The first and second inner conductors of the twin axial cable are each insulated from each other and are also insulated from a conductive shielding surrounding the inner conductors. The conductive shielding which surrounds the first lead, the second lead and a dielectric layer may have the shape of a hollow cylinder. An isolated physical protection may surround the conductive shielding. Thus, the transmission of the radio frequency signal in the coaxial mode and the transmission of the control signal in the differential mode can be performed with one cable comprising two inner conductors and a conductive shielding.

Preferably, at least one balun is arranged in the signal transmission line arrangement. The balun can be a toroidal balun. The balun in general here is used as a trap. Because the signal transmission line arrangement's conducive shielding with the leads is mechanical flexible, the balun can be manufactured by winding a portion of the signal transmission line in the toroidal shape around a core. In this way, the balun is integrated in the signal transmission line. This avoids to separately connect the balun as a discrete component to the signal transmission line by soldering or the like. The balun may be configured by winding a twin axial shielded conductor in the toroidal shape. This structure preferably is self-resonant at operating frequency or may also be tuned to resonance by using an additional capacitance.

The invention further provides a radio frequency antenna system for a magnetic resonance examination apparatus comprising a radio frequency coil and an active component connected to the radio frequency coil for radio frequency signal amplification, the signal transmission line arrangement as described above with the first lead and the second lead each extending from a first end to a second end, wherein the active component is connected to the first end of the first lead for transmitting the radio frequency signal, a detune control connected to the second end of the second lead for control signal transmission, the detune control being adapted for generating the control signal when no radio frequency signal is applied to the signal transmission line arrangement, the radio frequency antenna system further comprising at least one detune circuit interconnected between the signal transmission line arrangement and the radio frequency coil, and the detune circuit is adapted for detuning the radio frequency coil upon the control signal reception.

Here, the active component may comprise a preamplifier, an active impedance matching network and/or further components. The preamplifier is configured to amplify the magnetic resonance signal, that is a signal in the radio frequency band, received with a radio frequency coil such that an amplified radio frequency signal can be output to the signal transmission line arrangement.

The radio frequency antenna system may have multiple radio frequency coils e.g., in the form of a radio frequency coil array. The radio frequency signal is transmitted to the first end of the first lead of the signal transmission line arrangement via the active component and transmitted to the second end of the first lead via the signal transmission line arrangement in the coaxial mode. Preferably, an analog-digital-converter is connected to the second end of the first lead, such that the radio frequency signal is converted to a digital radio frequency signal, wherein the analog-digital-converter is also adapted for supplying the active component, such as the pre-amplifier with power via the first lead while also the radio frequency signal is transmitted. Therefore, the analog-digital-converter is provided with a bias tee for supplying the pre-amplifier. In this way a power supply can be provided via the first lead. Likewise, it is possible to incorporate the analog-digital-converter into the active component.

The detune control is designed to generate and transmit the control signal to the second end of the second lead when the signal transmission line arrangement is in the differential mode. The detune control transmits the control signal preferably with the second lead and the conductive shielding to which it is also connected for control signal transmission. For protection from the radio frequency signal, the detune control can be equipped with a pair of radio frequency chokes interconnected between the second lead and the detune control and/or the conductive shielding and the detune control.

The control signal is transmitted to the detune circuit in differential mode and in this particular case corresponds to a detune signal, so that the detune circuit detunes the radio frequency coil upon reception of the control signal that corresponding to the detune signal.

The ground potential can therefore be provided to the detune circuit with the control signal via the conductive shielding. Similarly, the ground potential of the active component can also be provided with the conductive shielding.

Basically, the detune circuit can be formed in different ways. According to a preferred embodiment of the invention, however, the detune circuit comprises a voltage-controlled switch or a current-controlled switch in series with a detuning inductor, wherein the switch and the detuning inductor are connected in parallel to the radio frequency coil such that the radio frequency coil is detuned by the detuning inductor by closing the switch upon the control signal reception. The current-controlled switch is preferably a PIN diode.

The voltage-controlled switch is preferably a field-effect transistor which may be in the form of a single pole double throw switch, which is conductive when closed and non-conductive when open. For this purpose, one of the contacts of the single pole double throw switch is not connected.

The voltage-controlled switch is therefore designed in such a way that, compared to the conventionally used PIN diode, no continuous current has to be provided for detuning to take place.

Various switches are conceivable. According to a preferred embodiment of the invention, however, the switch is a gallium nitride field-effect transistor, comprising a gate terminal connected to the first end of the second lead, and a source terminal connected to the conductive shielding and a drain terminal connected in parallel to the radio frequency coil.

Gallium nitride field-effect transistors hardly need any current at the gate, thus, do not require significant power to get switched, and ave extremely short switching times.

Basically, the control signal can be a low-frequency alternating current signal or a direct current signal. According to a preferred embodiment of the invention, however, the radio frequency antenna system comprises a rectifier interconnected between the first end of the second lead and the detune circuit such that the control signal is rectified employing the rectifier, and the rectified control signal is transmitted to the gate terminal of the voltage-controlled switch. Thus, the control signal is transmitted as an alternating current signal. Thereby it is especially preferred that the radio frequency antenna system additionally comprises at least a sensor and an interface with the signal transmission line arrangement, e.g. interconnected between the first end of the second lead and the rectifier, the interface comprising at least two connections, a first connection for the control signal transmission to the rectifier and a further connection for power supplying the at least one sensor with the detune control via the control signal. With the control signal being the alternating current signal, different channels can be provided for sensors via the interface, which therefore do not require a separate lead in the signal transmission line arrangement. The sensors may be sensors for monitoring a patient or impedance of the radio frequency coil or other radio frequency parameters such as radio frequency tuning or control of mutual radio frequency coil coupling or monitoring a detuning status. Furthermore, the sensor can be a temperature sensor, an acceleration sensor or a magnetic field sensor for measuring the magnetic field. The sensor signal can be an analog signal or a digital signal.

In this context, it should be noted that it is possible to control the sensors in different ways. According to a preferred embodiment of the invention, however, the radio frequency antenna system further comprises a control unit, wherein the control unit is connected to the interface for signal transmission and adapted for controlling the sensor. A sensor signal measured with the sensor is processed in the control unit. In the control unit, a channel is provided for each incoming signal, which can be implemented with analog or digital filtering. Another possibility is to implement a sequential variant in the control unit. The sensor signal is processed and stored in the control unit. The sensor signals are transmitted to the magnetic resonance examination apparatus when no radio frequency signal is received and no transmit radio frequency signal is emitted. In this way, electromagnetic interference can be avoided.

The invention further concerns a method of operating the radio frequency antenna system according as described above comprising the following steps: Determining if the emission of a transmit radio frequency signal with the magnetic resonance examination apparatus is impending, detuning of the radio frequency coil with the detuning circuit upon control signal transmission with the second lead in the differential mode, when it has been determined that the emission of the transmit radio frequency signal with the magnetic resonance examination apparatus is impending, stopping the detuning when the transmit radio frequency signal has been emitted, receiving the radio frequency signal, and transmitting the radio frequency signal with the first lead and the second lead of the signal transmission line arrangement in the coaxial mode.

According to a preferred embodiment of the invention, the radio frequency antenna system comprises a sensor, wherein the sensor is a frequency sensor such that the detuning of the radio frequency coil can be monitored with the sensor, the method comprising the following further steps which are performed during step the second step described above: Monitoring the detuning of the radio frequency coil employing the sensor, and supplying power to the active component employing the first lead of the signal transmission line arrangement.

The invention further provides a computer program for the radio frequency antenna system, comprising instructions which, when the program is executed by a computer, cause the computer to perform the method described above.

The invention also provides a magnetic resonance examination apparatus with the radio frequency antenna system according to the described above.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1a schematically depicts a signal transmission line arrangement according to a preferred embodiment of the invention,
Fig. 1b schematically depicts a signal transmission line arrangement according to another preferred embodiment of the invention,
Fig. 2 schematically depicts a radio frequency antenna system according to a preferred embodiment of the invention,
Fig. 3 schematically depicts a second radio frequency antenna system according to a preferred embodiment of the invention,
Fig. 4 schematically depicts a magnetic resonance examination apparatus with the radio frequency antenna system; and
Fig. 5 schematically depicts the scheme of a method of operating the radio frequency antenna system.

### DETAILED DESCRIPTION OF EMBODIMENTS

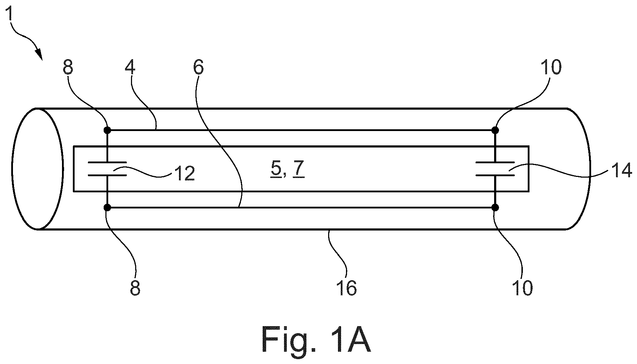

Fig. 1a schematically depicts a signal transmission line arrangement 1 according to a preferred embodiment of the invention with a first lead 4 and a second lead 6 extending from respective first ends 8 to respective second ends 10. Between the first lead 4 and the second lead 6 one ore more reactive elements 5 in form of a reactive unit 7 which is interconnected in such a way that a radio frequency signal can pass the reactive unit 7. The reactive unit 7 may be formed by a first capacitor 12 and a second capacitor 14. The first capacitor 12 is interconnected between the first ends 8, the second capacitor 14 is interconnected between the second ends 10. A conductive shielding 16 carrying a ground potential surrounds the first lead 4 and the second lead 6, wherein the first lead 4, the second lead 6 and the conductive shielding 16 are formed by a twin axial cable. The first lead 4 and the second lead 6 are formed by the inner conductors, the conductive shielding 16 is formed by the shielding of the twin axial cable. If the radio frequency signal is now applied to one of the ends, the first capacitor 12 and the second capacitor 14 are designed to have a low capacitive resistance and the first lead 4 and the second lead 6 transmit the radio frequency signal in a coaxial mode with a shared potential against the conductive shielding 16. However, for a lower frequency control signal applied to one of the ends 8, 10, the first capacitor 12 and the second capacitor 14 have a high capacitive resistance and the control signal is transmitted exclusively with the lead to which the control signal was applied, the second lead 6.

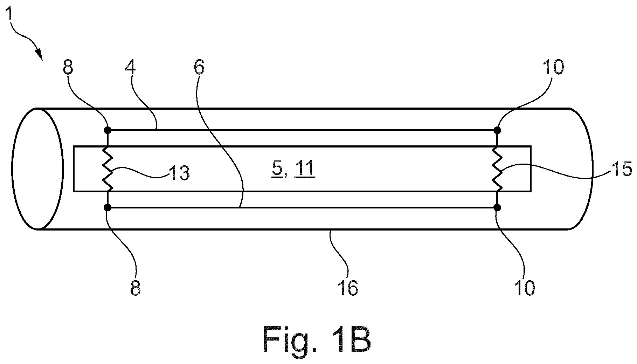

Fig. 1b schematically depicts a signal transmission line arrangement 1 according to another preferred embodiment of the invention with the first lead 4 and the second lead 6 extending from respective first ends 8 to respective second ends 10. Between the first lead 4 and the second lead 6 the reactive element 5 in form of an inductive unit 11 is interconnected in such a way that the control signal signal can pass the inductive unit 11. The inductive unit 11 is formed by a first inductor 13 and a second inductor 15. The first inductor 13 is interconnected between the first ends 8, the second inductor 15 is interconnected between the second ends 10. The conductive shielding 16 carrying the ground potential surrounds the first lead 4 and the second lead 6, wherein the first lead 4, the second lead 6 and the conductive shielding 16 are formed by the twin axial cable. The first lead 4 and the second lead 6 are formed by the inner conductors, the conductive shielding 16 is formed by the shielding of the twin axial cable. If the control signal is now applied to one of the ends, the first inductor 13 and the second inductor 15 are designed to have a low inductive resistance and the first lead 4 and the second lead 6 transmit the control signal in a coaxial mode with a shared potential against the conductive shielding 16. However, for the radio frequency signal applied to one of the ends 8, 10, the first inductor 13 and the second inductor 15 have a high inductive resistance and the radio frequency signal is transmitted exclusively with the lead to which the control signal was applied, the first lead 4.

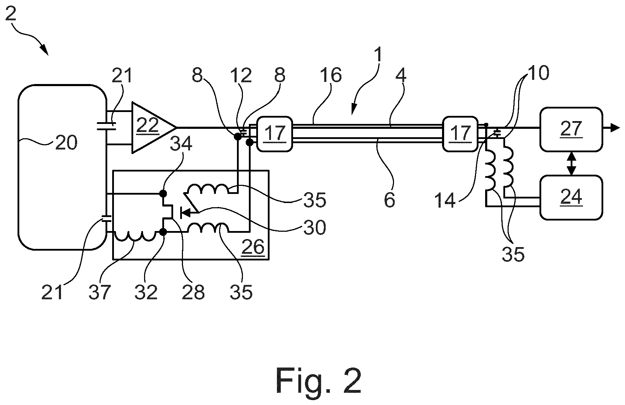

Fig. 2 schematically depicts a radio frequency antenna system 2 according to a preferred embodiment of the invention. In the present radio frequency antenna system 2, the signal transmission line arrangement 1 is used on the one hand in the coaxial mode for transmitting the radio frequency signal received with a radio frequency coil 20 and on the other hand in the differential mode for transmitting a control signal generated with a detuning control 24. The signal transmission line arrangement 1 is formed at the first ends 8 and at the second ends 10 with a balun 17 each.

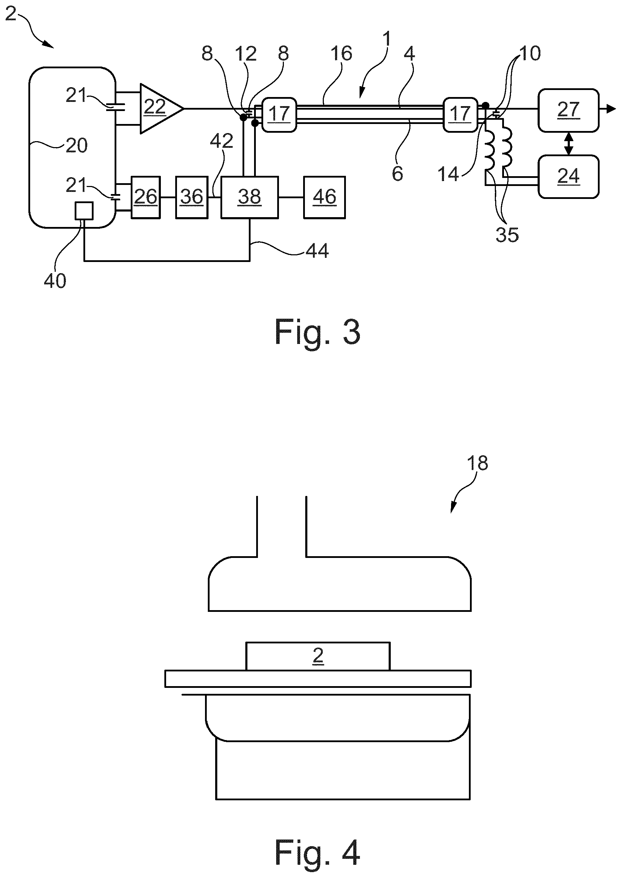

The detuning control 24 is connected to a radio frequency choke 35 and to the second end 10 of the second lead 6 as well as to the conductive shielding 16 for transmitting the control signal and the ground potential. When a transmit radio frequency signal is emitted from a magnetic resonance examination apparatus 18 shown in Fig. 4, the radio frequency coil 20 must be protected. This protection mechanism provides for detuning the radio frequency coil 20 with a detuning circuit 26. For this purpose, the detuning circuit 26 is connected to the first end 8 of the second lead 6 and to the conductive shielding 16 for receiving the control signal and the ground potential, respectively.

The detuning circuit 26 has a switch 28 that is a voltage-controlled switch 28, which is a single pole double throw switch in the form of a gallium nitride field effect transistor. A gate terminal 30 of the gallium nitride field effect transistor is connected to the first end 8 of the second lead 6 via an interconnected radio frequency choke 35. A source terminal 32 of the gallium nitride field effect transistor is connected on one side via an interconnected radio frequency choke 35 to the conductive shielding 16 and on the other side to a detune inductor 37. A drain terminal 34 is connected to the radio frequency coil 20 in the same way as the detune inductor 37.

In this example, the gallium nitride field-effect transistor is a depletion field-effect transistor. To switch the gallium nitride field effect transistor, a gate voltage is required, which is provided with the control signal. If the transmit radio frequency signal is now emitted, the voltage-controlled switch 28 is closed on receipt of the control signal generated with the detune control 24 and transmitted with the signal transmission line arrangement 1 in the differential mode, and the detune inductor 37 is connected in parallel with a radio frequency coil capacitor 21. Thereby, the radio frequency coil 20 is detuned. Simultaneously an analog-digital-converter 27 connected to the second end 10 of the first lead 4 supplies the preamplifier with power employing the first lead 4.

If, on the other hand, the transmit radio frequency signal is not emitted and the voltage-controlled switch 28 is still closed, the control signal is again generated by the detune control 24 and transmitted via the signal transmission line arrangement 1 to open the voltage-controlled switch 28 prior reception of the radio frequency signal with the radio frequency coil 20. The radio frequency signal is received with the radio frequency coil 20 and amplified via an active component 22, which is arranged in parallel with a further radio frequency coil capacitor 21 and is a preamplifier, and is transmitted to the first end 8 of the first lead 4. The signal transmission line arrangement 4 is then in the coaxial mode and the radio frequency signal is transmitted with the first lead 4 to the analog-digital converter 27.

Fig. 3 schematically depicts a second radio frequency antenna system according to a preferred embodiment of the invention. Here, the control signal is an alternating current signal. An interface 38 is connected to the first end 8 of the second lead 6 and the conductive shielding 16. Because the control signal is an alternating current signal, the control signal in the interface 38 can be divided into a multitude of channels. The interface 38 in this particular embodiment has a first connection 42 connected to a rectifier 36 and a further connection 44 connected to a sensor 40. Similarly, the interface 38 is connected to a control unit 46 adapted to control the sensor 40 corresponding to a frequency sensor for monitoring the detuning of the radio frequency coil 20. The rectifier 36 is connected to the detuning circuit 26 for transmitting the rectified control signal.

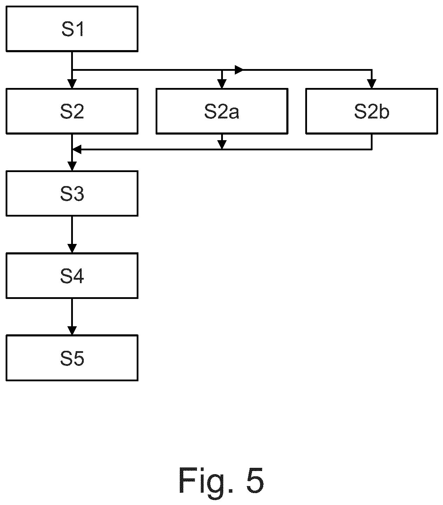

Fig. 5 schematically depicts the scheme of a method of operating the radio frequency antenna system 2 comprising the following steps: In a first step S1, it is determined, if the emission of a transmit radio frequency signal with the magnetic resonance examination apparatus 18 is impending. In a second step S2 the detuning of the radio frequency coil 20 with the detuning circuit 26 upon control signal transmission with the second lead 6 in the differential mode is performed, when it has been determined that the emission of the transmit radio frequency signal with the magnetic resonance examination apparatus 18 is impending. Parallel to this second step, in step S2a the detuning of the radio frequency coil 20 is monitored, employing the sensor 40. Additionally, parallel to the second step, in step S2b power is supplied to the active component 22 employing the first lead 4 of the signal transmission line arrangement 1. In a third step S3 the detuning is stopped when the transmit radio frequency signal has been emitted and the radio frequency signal is then received in a fourth step S4. In the fifth step S5 the radio frequency signal is transmitted with the first lead 4 and the second lead 6 in the coaxial mode.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| Signal transmission line arrangement | 1 |
| radio frequency antenna system | 2 |
| lead | 3 |
| first lead | 4 |
| reactive element | 5 |
| second lead | 6 |
| capacitive unit | 7 |
| first end | 8 |
| second end | 10 |
| inductive unit | 11 |
| first capacitor | 12 |
| first inductor | 13 |
| second capacitor | 14 |
| second inductor | 15 |
| conductive shielding | 16 |
| balun | 17 |
| magnetic resonance examination apparatus | 18 |
| radio frequency coil | 20 |
| radio frequency coil capacitor | 21 |
| active component | 22 |
| detune control | 24 |
| detune circuit | 26 |
| analog-digital-converter | 27 |
| switch | 28 |
| gate terminal | 30 |
| source terminal | 32 |
| drain terminal | 34 |
| radio frequency choke | 35 |
| rectifier | 36 |
| detuning inductor | 37 |
| interface | 38 |
| sensor | 40 |
| first connection | 42 |
| further connection | 44 |
| control unit | 46 |

## Claims

1. Signal transmission line arrangement (1) for a radio frequency antenna system (2) of a magnetic resonance examination (18) apparatus comprising
at least two leads (3) arranged within a conductive shielding (16), the leads (3) being galvanically conductive and extending from a first end (8) to a second end (10), wherein
the leads (3) are reactively coupled by at least one reactive element (5) galvanically interconnected between the first ends (8) and the second ends (10), such that the leads (3) are connected in parallel with the respective reactive element (5) and the reactive coupling gives rise to respective different transmission modes of signal propagation of signals in respective frequency bands.

2. Signal transmission line arrangement (1) according to claim 1, wherein the at least one reactive element (5) is at least one capacitive unit (7), such that the capacitive coupling of the leads (3) gives rise to
a coaxial mode supported by both leads (3) for radio frequency signal transmission, wherein the capacitive unit (7) is configured for having a lower capacitive resistance in a radio frequency band, and
a differential mode supported by the conductive shielding (16) and one of the leads (3) for transmission of a low-frequency band control signal, wherein the capacitive unit (7) is configured for having a higher capacitive resistance in the low-frequency band.

3. Signal transmission line arrangement (1) according to claim 1, wherein the at least one reactive element (5) is at least one inductive unit (11), such that the inductive coupling of the leads (3) gives rise to
a coaxial mode supported by both leads (3) for transmission of a low-frequency band control signal, wherein the inductive unit (11) is configured for having a lower inductive resistance in the low-frequency band, and
a differential mode supported by the two leads (3) for radio frequency signal transmission, wherein the inductive unit (11) is configured for having a higher inductive resistance in a radio frequency band.

4. Signal transmission line arrangement (1) according to claim 2 wherein the at least two leads (3) comprise a first lead (4) and a second lead (6) and the capacitive unit (7) comprises a first capacitor (12) and a second capacitor (14) and
the first capacitor (12) and the second capacitor (14) are each interconnected between the first ends (8) and the second ends (10) of the first lead (4) and the second lead (6) such that the radio frequency signal is transmittable employing the first lead (4) and the second lead (6) in the coaxial mode against a ground potential in the conductive shielding (16), and the control signal is transmittable in the differential mode employing the first lead (4) and the conductive shielding (16) or the second lead (6) and the conductive shielding (16).

5. Signal transmission line arrangement (1) according to claim 3 wherein the at least two leads (3) comprise a first lead (4) and a second lead (6) and the inductive unit (11) comprises a first inductor (13) and a second inductor (15) and
the first inductor (13) and the second inductor (15) are each interconnected between the first ends (8) and the second ends (10) of the first lead (4) and the second lead (6) such that the control signal is transmittable employing the first lead (4) and the second lead (6) in the coaxial mode, and the radio frequency signal is transmittable in the differential mode employing the first lead (4) and the conductive shielding (16) or the second lead (6) and the conductive shielding (16).

6. Signal transmission line arrangement (1) according to any one of the previous claims, wherein the first lead (4), the second lead (6) and the conductive shielding (16) are formed by a twin axial cable or a shielded twisted pair cable, wherein the first lead (4) and the second lead (6) are formed by the inner conductors of the twin axial cable or the twisted pair cable, and the conductive shielding (16) is formed by the shielding of the twin axial cable or the shielding of the twisted pair cable.

7. Radio frequency antenna system (2) for a magnetic resonance examination apparatus (18), comprising
a radio frequency coil (20) and an active component (22) connected to the radio frequency coil (20) for radio frequency signal amplification,
the signal transmission line arrangement (1) according to any one of claims 1, 2, 4 or 6, wherein
the active component (22) is connected to the first end (8) of the first lead (4) for transmitting the radio frequency signal,
a detune control (24) connected to the second end (10) of the second lead (6) for control signal transmission,
the detune control (24) being adapted for generating the control signal when no radio frequency signal is applied to the signal transmission line arrangement (1), the radio frequency antenna system (2) further comprising
at least one detune circuit (26) interconnected between the signal transmission line arrangement (1) and the radio frequency coil (20), and
the detune circuit (26) is adapted for detuning the radio frequency coil (20) upon the control signal reception.

8. Radio frequency antenna system (2) according to claim 7, wherein the detune circuit (26) comprises a voltage-controlled switch (28) or a current-controlled switch (28) in series with a detuning inductor (36), wherein
the switch (28) and the detuning inductor (36) are connected in parallel to the radio frequency coil (20) such that the radio frequency coil (20) is detuned by the detuning inductor (36) by closing the switch (28) upon the control signal reception.

9. Radio frequency antenna system (2) according to claim 8, wherein the switch (28) is a gallium nitride field-effect transistor, comprising
a gate terminal (30) connected to the first end (8) of the second lead (6),
a source terminal (32) connected to the conductive shielding (16), and a drain terminal (34) connected in parallel to the radio frequency coil (20).

10. Radio frequency antenna system (2) according to claim 9 with a rectifier (36) interconnected between the first end (8) of the second lead (6) and the detune circuit (26) such that the control signal is rectified employing the rectifier (36), and
the rectified control signal is transmitted to the gate terminal (30) of the switch (28).

11. Radio frequency antenna system (2) according to claim 10 with at least a sensor (40) and an interface (38) interconnected between the first end (8) of the second lead (6) and the rectifier (36),
the interface (38) comprising at least two connections (42, 44),
a first connection (42) for the control signal transmission to the rectifier (36) and a further connection (44) for power supplying the at least one sensor (40) with the detune control (24) via the control signal.

12. Method of operating the radio frequency antenna system (2) according to any one of the claims 7 to 11 comprising the following steps:
S1) Determining if the emission of a transmit radio frequency signal with the magnetic resonance examination apparatus (18) is impending,
S2) detuning of the radio frequency coil (20) with the detuning circuit (26) upon control signal transmission with the second lead (6) in the differential mode, when it has been determined that the emission of the transmit radio frequency signal with the magnetic resonance examination apparatus (18) is impending,
S3) stopping the detuning when the transmit radio frequency signal has been emitted,
S4) receiving the radio frequency signal, and
S5) transmitting the radio frequency signal with the first lead (4) and the second lead (6) of the signal transmission line arrangement (1) in the coaxial mode.

13. Method according to claim 12 with a sensor (40), wherein the sensor (40) is a frequency sensor such that the detuning of the radio frequency coil (20) can be monitored with the sensor (40), comprising the following further steps which are performed during step S2:
S2a) Monitoring the detuning of the radio frequency coil (20) employing the sensor (40), and
S2b) supplying power to the active component (22) employing the first lead (4) of the signal transmission line arrangement (1).

14. Computer program for the radio frequency antenna system (2), comprising instructions which, when the program is executed by a computer, cause the computer to perform a method according to claim 12 or 13.

15. Magnetic resonance examination apparatus (18) with the radio frequency antenna system (2) according to any one of the claims 4 to 9.
